# EUROPEAN PATENT APPLICATION

(11) **EP 3 945 148 A1**
(43) Date of publication of application: **02.02.2022**
(21) Application number: 20187887.3
(22) Date of filing: 27.07.2020
(51) Int. Cl.: C30B 13/24, C30B 15/16

(54) **LASER-BASED AFTERHEATING FOR CRYSTAL GROWTH**

(71) Applicant: ScIDre Scientific Instruments Dresden GmbH, 01069 Dresden (DE)
(72) Inventor: SCHOENDUBE, Robert, 01069 Dresden (DE)
(74) Representative: Kailuweit & Uhlemann Patentanwälte Partnerschaft mbB

(57) **Abstract**

A crystal-growth apparatus (10, 10',10") and a crystal-growth method for growing a crystal (21) from a molten feed material (23) are presented, where in addition to a molten-zone heater, at least one afterheater laser (5) is arranged to heat an extended afterheater zone (50), the afterheater zone (50) at least partly overlapping a solidification zone (210) adjacent to the molten zone (230). The crystal-growth apparatus (10, 10',10") and the crystal-growth method may be used for thermal treatment to reduce crack formation or thermal stress in grown crystals (21).

## Description

The present invention relates to a crystal-growth apparatus for growing a crystal from a molten feed material, a crystal-growth method for growing a crystal from a molten feed material and the use of said apparatus and said method.

An application of this invention includes its use in single-crystal growth techniques involving solidification of a molten feed material in crystallized form.

An example for such a technique is the Czochralski process, where an oriented seed crystal is dipped into the molten feed material and slowly pulled upwards while being rotated.

Another example is the zone-melting process, in which a narrow region of feed material, e.g. a single-crystalline or a polycrystalline rod, is melted, and this so-called molten zone is moved along the rod, creating two solid interfaces. As the zone moves, e.g. by moving the heater or furnace or the rod, material from one interface dissolves in the molten zone and is recrystallized at the other interface, with purification occurring for those impurities whose solubility in the liquid is different than that in the solid. Thus, impurities are moved to one end of the rod, leaving a very pure crystal behind.

The floating-zone (FZ) process is an important variant of the zone-melting process. Making use of a seed crystal, it allows for crucible-free growth and eliminates possible contamination from the crucible material as well as stresses due to differential expansion between the crystal and container. The FZ process has the vertically positioned growing crystal at the bottom or at the top, and the melting rod of the feed material at the other side, with the molten zone floating due to relative movement between the molten-zone heater and crystal-rod arrangement.

A major problem in the production of crystals by solidification of a molten feed material is cracking due to thermal stress in the newly formed crystal. To heat the feed material above the melting point, very high temperatures of up to 3000 °C are often necessary. This creates large temperature differences between the heated melt pool in the molten zone and the unheated crystallization area. Solidification from the melt thus also leads to a very high temperature gradient within the resulting crystal, which causes enormous thermal stresses. These stresses often lead to cracks in the crystal or the formation of other defects in the crystal lattice, which render the material useless or greatly reduce its quality.

It is generally known that the temperature gradient can be reduced by additionally heating the solidified material in vicinity to the molten zone. Apart from the well-established use of carbon heaters, a number of patents disclose conventional resistive and inductive afterheating techniques. By way of example, DE 10 2004 058 547 A1 describes the application of an inductive heat input by a heating coil operated with radio frequency for afterheating in a floating-zone process. Inductive afterheating is also shown in GB 1 045 526 A.

While such conventional heaters can be used for metallic samples and in a protective gas atmosphere (usually argon) to achieve the desired heating effect, an atmosphere with high oxygen content is often necessary for the production of oxide materials. In particular such oxide compounds with very diverse electronic and magnetic properties are currently the focus of research, e.g. materials with intrinsic metal-insulator transitions or high-temperature superconductors. Often, however, it is precisely these compounds that are very susceptible to thermal stress. In combination with the extremely high temperatures, the high oxygen partial pressure leads to severe limitations in the operation of conventional afterheaters. As a result, there are practically no conventional afterheaters available for this class of materials that can reach sufficiently high temperatures.

There are several alternative approaches for passively distributing heat away from the molten zone. In US 4,248,645 A the distribution of heat is achieved by a bar of a material with a high thermal conductivity coupled to a heat sink. In US 2010 282 160 A1 a heat sink in the form of a heat exchanger is used for the same purpose.

DE 2 557 186 A1 discloses a passive afterheating arrangement using a radiation shield around the molten zone. A similar arrangement is shown in EP 0 725 168 A2.

These passive arrangements suffer from poor adjustability and adaptability.

Another approach for afterheating related to the growth of small single crystalline fibers is described in WO 2008/092 097 A2. There is disclosed the use of mirrors to split a CO₂ laser beam into a first portion for melting the material and a second portion forafterheating. Using a concentric bifocal mirror, the first portion is focused on the molten zone and the second portion on an afterheated zone.

The subject-matter described in WO 2008/092 097 A2 suffers from several drawbacks including the use of additional, sensitive optical components and a low versatility in terms of length and position adjustment of the afterheated zone. It is furthermore not possible to adjust the temperature profile of the afterheated zone.

The present invention seeks to provide an apparatus and a method presenting an option for afterheating a crystal grown from molten feed material up to very high temperatures in a stable and permanent way, the method and apparatus being independent of the surrounding atmosphere.

A first aspect of the invention provides a crystal-growth apparatus for growing a crystal from a molten feed material, the apparatus comprising:
- a molten-zone heater to melt the feed material in a molten zone;
- at least one afterheater laser arranged to emit an afterheater laser beam to heat an extended afterheater zone, the afterheater zone at least partly overlapping a solidification zone adjacent to the molten zone.

In the context of the invention; the "afterheater zone" specifies the part of the feed material and/or the grown crystal which is directly irradiated by the afterheater laser beam. The direct radiation of the afterheater laser may correspond to the radiation that travels the shortest possible path from the laser source to said afterheater zone. It is not excluded that parts outside the afterheater zone may also experience a temperature increase as compared to an apparatus without an afterheater, e.g. due to heat conduction from the afterheater zone or indirect radiation.

The afterheater zone may overlap at least partly with the solidification zone of the crystal grown from its molten feed material, which is to be understood in such a way that it also falls within the scope of the invention for the afterheater zone to overlap not only the solidification zone, but also further areas, e.g. of the feed material.

The term "solidification zone" is used to specify the zone where the molten feed material has solidified into the desired -crystalline structure due to its temperature having fallen below the melting temperature.

The term "crystal" or "crystalline" is used to relate to any type of solid with a crystalline atomic structure that can be grown from a molten feed material. The crystal may comprise polycrystalline and/or single crystalline areas, wherein polycrystalline areas are especially common at the beginning and at the boundaries of the solidification zone. Preferably, the crystal has large single-crystalline areas. It falls within scope of the invention for the grown crystal to exhibit crystallographic defects that disrupt the crystal structure. The crystal may comprise vacancies, interstitials, dislocations, grain boundaries and/or impurities.

The afterheater zone extends over a certain area of at least the solidification zone, wherein the extension of the afterheater zone may depend on the irradiation area of the afterheater laser beam with respect to the solidification zone. Preferably, the extension of the afterheater zone is larger than the extension of the molten zone.

The afterheater zone is situated adjacent to the molten zone, which, in the context of the invention, is to be understood such that the afterheater zone is in close proximity or nearby the molten zone, but not necessarily directly, i.e. seamlessly, adjoining the molten zone.

The at least one afterheater laser may or may not have an adjustable output power. Preferably, the at least one afterheater laser may have a maximum output power which is large enough to heat the afterheater zone to a temperature equal or at least close to the melting temperature of the feed material. The maximum total output power may typically range from 500 W to 10 kW, preferably from 750 W to 10 kW, depending, among others, on the size and/or the material of the crystal. The maximum total output power may be divided among several afterheater lasers, wherein each of the several afterheater lasers may have a maximum output power in the range from 10 W to 1500 W. By way of an example for a typical FZ process, the maximum total output power may be divided among three afterheater lasers with a maximum output power of 800 W each, or five afterheater lasers with a maximum output power of 500W each, or 27 afterheater lasers with a maximum output power of 30 W each.

The afterheater laser beam may be understood as the total light emitted by the afterheater laser in the direction of the afterheater zone. Preferably, the afterheater laser beam is defocused. Preferably, the molten-zone heater comprises at least one laser, which may be used for melting a feed material at temperatures of up to several 1000°C.

According to an embodiment of the invention, the crystal-growth apparatus may further comprise irradiation-area adjustment means to adjust the irradiation area of the afterheater laser beam.

Preferably, the irradiation-area adjustment means is operable to adjust the size and/or the position of the irradiation area of the afterheater laser beam. The size and/or the position of the irradiation area may be varied while the afterheater laser is in operation, so that either a smaller or a larger part of the solidification zone may be heated by the afterheater laser beam in a well-defined manner.

Preferably, the irradiation-area adjustment means comprise at least one adjustable defocusing means. The defocusing means may act as beam expanders. They may be of telescopic or prismatic nature.

Preferably, the irradiation-area adjustment means comprise at least one movable lens. The movable lens may be a converging lens or a diverging lens. The size and/or the position of the irradiation area may depend on the relation between the variable distance of the laser beam source from the lens plane and the focal length of the lens.

According to a further embodiment of the invention, the at least one afterheater laser is a diode laser. The diode laser may or may not have an adjustable output power. The diode laser may emit infrared light of a wavelength of about 1 µm.

The crystal-growth apparatus may comprise more than one afterheater laser. The crystal-growth apparatus may comprise several afterheater lasers, preferably between 2 and 50, more preferably between 3 and 40, especially preferably between 3 and 30. These several afterheater lasers may be arranged in any feasible way around the specimen to be heated by them. By way of example, these several afterheater lasers may be arranged surrounding the specimen along its circumference. Advantageously, this arrangement allows for a radially uniform temperature distribution in the afterheater zone. By way of another example, these several afterheater lasers may be arranged along the direction of motion of the molten zone. Advantageously, this arrangement allows for a defined temperature profile with respect to the afterheater zone to be set along the direction of motion of the molten zone.

According to a further embodiment of the invention, the crystal-growth apparatus comprises an odd number N of afterheater lasers, with N > 1, wherein the afterheater lasers may surround the afterheater zone circumferentially. Preferably, N ranges from 3 to 15, more preferably from 3 to 9. Advantageously, arranging an odd number of afterheater lasers circumferentially around the sample allows for a radially uniform temperature distribution in the afterheater zone and for the use of beam traps for the transmitted laser beams.

According to a further embodiment of the invention, the crystal-growth apparatus comprises several afterheater lasers arranged to have variable and/or superimposable irradiation areas and/or arranged to regulate the temperature profile of the afterheater zone, e.g. in the direction of motion of the molten zone. The several afterheater lasers may be arranged around the specimen. They may have adjustable input powers. There may be provided irradiation-area adjustment means allocated to at least one of the several afterheater lasers.

Advantageously, this embodiment permits the afterheater zone to be divided into areas that can be heated to different temperatures. By way example, this allows for controlled cooling of the solidification zone without the temperature gradient, e.g. the temperature gradient along the direction of motion of the molten zone, exceeding critical values.

According to another embodiment of the invention, the afterheater laser is arranged to heat an afterheater zone which is directly, i.e. seamlessly, adjacent to the molten zone and/or at least partly overlaps the molten zone. Thus, the temperature gradient between the molten zone and the directly adjoining solidification zone can be reduced in an optimal way. The afterheater zone partly overlapping the molten zone may facilitate melting the feed material in the molten zone. According to another embodiment of the invention, the afterheater laser is arranged to heat an afterheater zone which overlaps at least partly with the solidification zone and the zone of the feed material which is adjacent to the molten zone. The afterheater laser may also heat the molten zone between said zone of the feed material and the solidification zone.

Another aspect of the invention provides a crystal-growth method for growing a crystal from a molten feed material, wherein in addition to heating the molten zone, an extended afterheater zone which partly overlaps the solidification zone adjacent to the molten zone, is heated by at least one afterheater laser beam emitted by at least one afterheater laser.

The afterheater zone extends over a certain area of at least the solidification zone, wherein the extension of the afterheater zone may depend on the irradiation area of the afterheater laser beam with respect to the solidification zone.

The afterheater zone is situated adjacent to the molten zone, which, in the context of the invention, is to be understood such that the afterheater zone is in close proximity or nearby the molten zone, but not necessarily directly, i.e. seamlessly, adjoining the molten zone.

According to an embodiment of the method, the irradiation area of the afterheater laser beam emitted by the afterheater laser is adjustable by irradiation-area adjustment means. Preferably, the afterheater laser beam emitted by the afterheater laser is adjustable in size and/or position by the irradiation-area adjustment means.

According to another embodiment of the method, the temperature profile of the afterheater zone is adjustable. Advantageously, this allows for cooling the grown crystal in a well-defined way and may further reduce thermal stress.

According to another embodiment of the method, the afterheater zone is directly adjacent to the molten zone and/or at least partly overlaps the molten zone.

According to another embodiment of the method, the afterheater zone at least partly overlaps the solidification zone and the zone of the feed material which is adjacent to the molten zone.

A further aspect of the invention is related to the use of the crystal-growth apparatus or the crystal-growth method in a zone-melting-type or a Czochralski-type or a Bridgman-type apparatus or method for growing crystals.

A zone-melting-type method may comprise melting a narrow region of feed material, e.g. a single crystalline or a polycrystalline rod, and moving this molten zone along the rod. The zone-melting-type method includes the floating-zone-type method comprising the molten zone floating due to relative movement between the molten-zone heater and the crystal-rod arrangement.

A Czochralski-type method may comprise dipping an oriented seed crystal into the molten feed material and slowly pulling the seed crystal upwards while rotating it.

A Bridgman-type method may comprise translating a molten feed material from a hot zone to a cold zone of a furnace.

The invention may be used with rods of any cross-sectional geometry.

Another aspect relates to the use of the invention with aforesaid features for thermal treatment to reduce crack formation or thermal stress in crystals grown from a molten feed material and/or to facilitate the melting process of the feed material.

Throughout this description, the term "at least one" is used for the sake of brevity, which can mean: one, exactly one, several (e.g. exactly two, or more than two), many (e.g. exactly three or more than three), etc. However, "several" or "many" does not necessarily mean that there are several or many identical elements, but several or many essentially functionally identical elements.

It is appreciated that certain features of the invention, which are, for clarity, described in the context of separate embodiments, may also be provided in combination in a single embodiment. Conversely, various features of the invention, which are, for brevity, described in the context of a single embodiment, may also be provided separately or in any suitable sub-combination.

The following detailed description of exemplary embodiments of the invention is presented to enable any person skilled in the art to make and use the disclosed subject matter in the context of one or more particular implementations. Various modifications to the disclosed implementations will be readily apparent to those skilled in the art, and the general principles defined herein may be applied to other implementations and applications without departing from scope of the disclosure. Thus, the present disclosure is not intended to be limited to the described or illustrated implementations, but is to be accorded the widest scope consistent with the principles and features disclosed herein.

Implementations of the invention will be described, by way of example only, with reference to accompanying drawings in which:
Figure 1 schematically shows a crystal-growth apparatus according to prior art and the associated temperature profile across the specimen along the direction of motion of the molten zone;
Figure 2 schematically shows a crystal-growth apparatus according to the invention and the associated temperature profile across the specimen along the direction of motion of the molten zone;
Figure 3 schematically shows a crystal-growth apparatus according to the invention where the afterheater zone partly overlaps the zone of the feed material and the solidification zone as well as the molten zone;
Figure 4 schematically shows a crystal-growth apparatus according to the invention where several afterheater lasers are successively arranged in the direction of motion of the molten zone;
Figure 5 schematically shows a crystal-growth apparatus according to the invention where several afterheater lasers are arranged circumferentially surrounding the specimen.

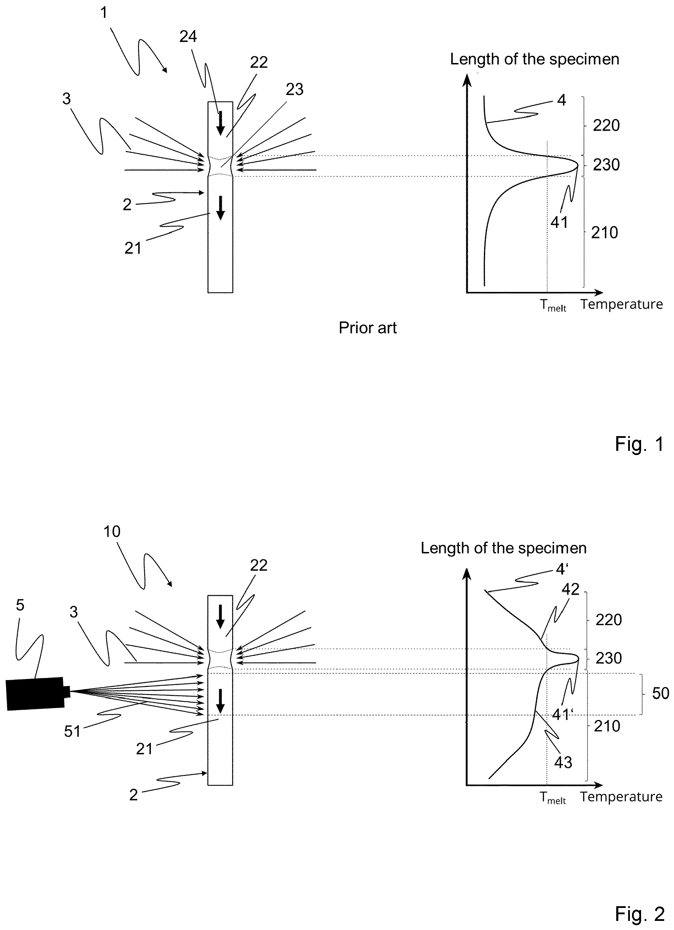

Figure 1 shows a crystal-growth apparatus, w.l.o.g. a floating-zone (FZ) apparatus 1, acting on a specimen 2, according to prior art without the use of an afterheating system. The specimen 2 comprises a crystalline part 21 in the solidification zone 210. The crystalline material 21 is grown by melting a polycrystalline-material feed rod 22 located in the feed-material zone 220 and moving the melt pool 23 in the narrow molten zone 230 along the rod 22 by moving the specimen 2 in the direction of motion depicted by arrows 24. The molten zone 230 is heated by thermal radiation to a temperature slightly above the melting temperature of the feed material Tₘₑₗₜ. The thermal radiation may be focused laser light 3 emitted by e.g. at least one CO₂ or YAG laser, or focused light of at least one polychromatic arc lamp or halogen lamp (not shown for the sake of clarity). The temperature profile 4 that develops over the length of the specimen 2, the length being the dimension of the specimen 2 in the direction of motion 24 of the specimen 2, exhibits a narrow peak 41 in the molten zone 230 with large temperature gradients in the feed-material zone 220 and the solidification zone 210. Especially this steep decrease of temperature in the solidification zone 210 may lead to pronounced thermal stress in the single-crystalline material 21.

Figure 2 shows a crystal-growth apparatus, w.l.o.g. a floating-zone (FZ) apparatus 10, according to the invention. In addition to the molten-zone heater (not shown), the FZ apparatus 10 comprises at least one diode laser 5 heating an afterheater zone 50, which partly overlaps the solidification zone 210. Adjustable defocusing means (not shown) act on the diode laser 5, which thus emits defocused laser light 51, in contrast to the focused laser light 3 emitted by the molten-zone heater. The temperature profile 4' over the length of the specimen 2 exhibits a narrow peak 41' in the molten zone 230, similar to that shown in Figure 1. In contrast to the temperature profile 4 of Figure 1, the temperature profile 4' is characterised by a shoulder 42 in the feed-material zone 220 and a pronounced shoulder 43 in the solidification zone 210, which occur because of the additional heat input by the diode laser 5 into the afterheater zone 50. While the afterheater zone 50, comprising at least a part of the solidification zone 210, is directly irradiated by the diode laser 5, the shoulder 42 in the feed-material zone 220 occurs mainly due to conduction of heatfrom the solidification zone 210 to the feed-material zone 220. The shoulder 43 results in a significantly reduced temperature gradient in the solidification zone 210, thus reducing thermal stress and the proneness to the formation of cracks in the single-crystalline material 21.

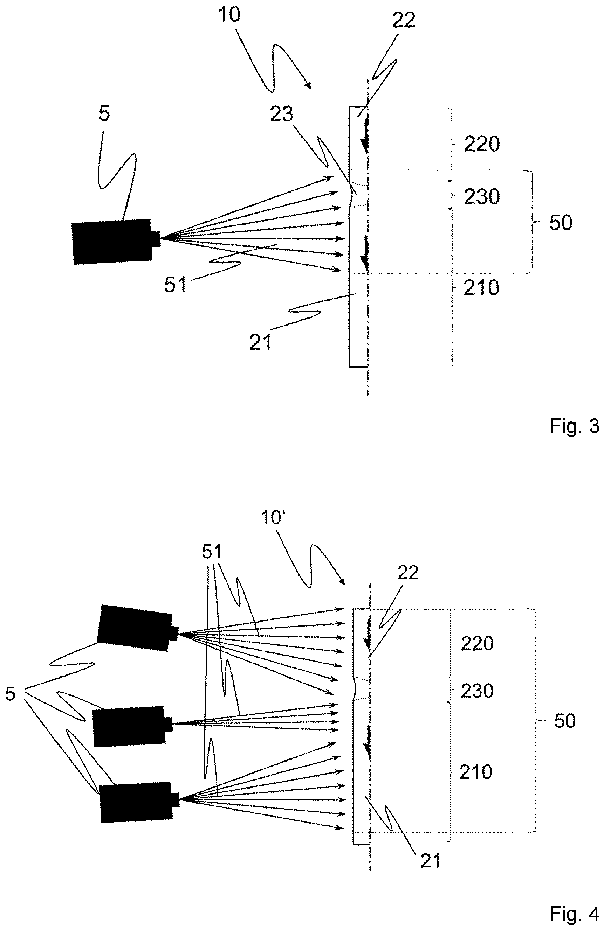

Figure 3 shows an FZ apparatus 10 similar to that of Figure 2, wherein the defocusing means (not shown) acting on the diode laser 5 are adjusted such that the irradiation area of the defocused laser light 51, and thus the afterheater zone 50, is larger than in Figure 2. The afterheater zone 50 not only overlaps with at least a part of the solidification zone 210, but also the molten zone 230 and at least a part of the feed-material zone 220.

The focused laser light acting on the melt pool 23 has been omitted for the sake of clarity.

Figure 4 shows an FZ apparatus 10' similar to that of Figure 2 with three diode lasers 5. The diode lasers 5 are positioned and/or their respective defocusing means (not shown) are adjusted such that their irradiation areas overlap, which ensures that the temperature gradient remains small across the entire length of the afterheater zone 50. The afterheater zone 50 may extend over the whole solidification zone 210, the molten zone 230 and the whole feed-material zone 220. The apparatus 10' allows for controlled cooling of the crystalline material 21 in the solidification zone 210, i.e. the temperature profile across the length of the specimen 2 can be adjusted to largely reduce thermal stress.

The focused laser light acting on the melt pool 23 has been omitted for the sake of clarity.

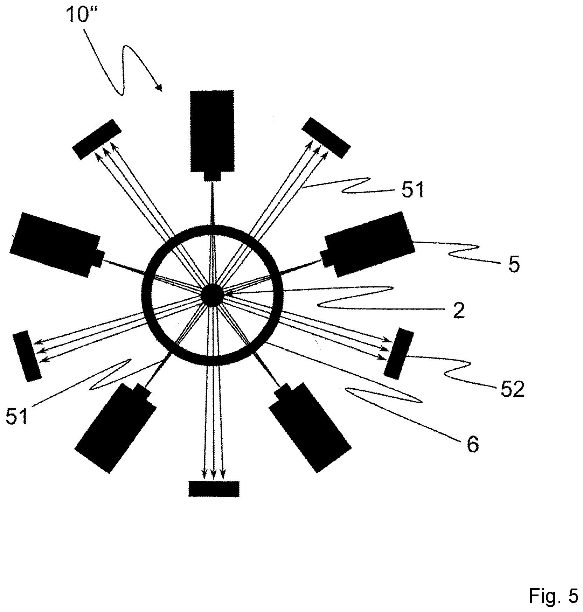

Figure 5 shows the bottom view of an FZ apparatus 10" with five diode lasers 5 arranged around the circumference of the specimen 2, which ensures a uniform temperature distribution in relation to the cross-section of the specimen 2. The diode lasers 5 are positioned outside a process chamber 6, which may provide an environment as needed for growing certain types of crystals, e.g. a high partial pressure of oxygen. The arrangement of an odd number of diode lasers 5 enables the use of beam traps 52 to absorb the defocused laser light 51 transmitted through the specimen 2, wherein one beam trap 52 is assigned to each diode laser 5.

### List of reference signs

- 1: FZ apparatus according to prior art
- 10, 10', 10": FZ apparatus according to the invention
- 2: specimen
- 21: Crystalline material
- 210: Solidification zone
- 22: Polycrystalline material feed rod
- 220: Feed-material zone
- 23: Melt pool
- 230: Molten zone
- 24: Direction of motion of the specimen
- 3: Focused laser light
- 4, 4': Temperature profile
- 41, 41': Temperature peak
- 42: Shoulder in temperature profile
- 43: Shoulder in temperature profile
- 5: Diode laser
- 50: Afterheater zone
- 51: Defocused laser light
- 52: Beam trap
- 6: Process chamber

## Claims

1. A crystal-growth apparatus (10, 10',10") for growing a crystal (21) from a molten feed material (23), comprising
- a molten-zone heater to melt the feed material in a molten zone (230);
- at least one afterheater laser (5) arranged to emit an afterheater laser beam (51) to heat an extended afterheater zone (50), the afterheater zone (50) at least partly overlapping a solidification zone (210) adjacent to the molten zone (230).

2. The crystal-growth apparatus (10, 10',10") according to claim 1, further comprising irradiation-area adjustment means to adjust the irradiation area of the afterheater laser beam (51).

3. The crystal-growth apparatus (10, 10', 10") according to claim 2, wherein the irradiation-area adjustment means comprise at least one adjustable defocusing means.

4. The crystal-growth apparatus (10, 10', 10") according to claim 2 or 3, wherein the irradiation-area adjustment means comprise at least one movable lens.

5. The crystal-growth apparatus (10, 10', 10") according to any of the preceding claims, wherein the at least one afterheater laser is a diode laser (5) with or without adjustable output power.

6. The crystal-growth apparatus (10") according to any of the preceding claims, wherein the crystal-growth apparatus (10") comprises an odd number N of afterheater lasers (5) with N > 1, the afterheater lasers (5) circumferentially surrounding the afterheater zone (50).

7. The crystal-growth apparatus (10') according to any of the preceding claims, wherein the crystal-growth apparatus (10') comprises several afterheater lasers (5) arranged to have variable and/or superimposable irradiation areas and/or arranged to regulate the temperature profile (4') of the afterheater zone (50).

8. The crystal-growth apparatus (10, 10', 10") according to any of the preceding claims, wherein the at least one afterheater laser (5) is arranged to heat an afterheater zone (50) which is directly adjacent to the molten zone (230) and/or at least partly overlaps the molten zone (230).

9. The crystal-growth apparatus (10, 10', 10") according to any of the preceding claims, wherein the afterheater laser (5) is arranged to heat an afterheater zone (50) overlapping at least partly with the solidification zone (210) and the zone of the feed material (220) which is adjacent to the molten zone (230).

10. A crystal-growth method for growing a crystal (21) from a molten feed material (23), wherein in addition to heating the molten zone (230), an extended afterheater zone (50) which partly overlaps a solidification zone (210) adjacent to the molten zone (230), is heated by at least one afterheater laser beam (51) emitted by at least one afterheater laser (5).

11. The crystal-growth method of claim 10, wherein the irradiation area of the afterheater laser beam (51) emitted by the afterheater laser (5) is adjustable by irradiation-area adjustment means.

12. The crystal-growth method according to claim 10 or 11, wherein the temperature profile (4') of the afterheater zone (50) is adjustable.

13. The crystal-growth method according to any of the claims 10 to 12, wherein the afterheater zone (50) is directly adjacent to the molten zone (230) or at least partly overlaps the molten zone (230).

14. The crystal-growth method according to any of the claims 10 to 13, wherein the afterheater zone (50) at least partly overlaps the solidification zone (210) and the zone of the feed material (220) which is adjacent to the molten zone (230).

15. Use of the crystal-growth apparatus (10, 10', 10") according to any of the claims 1 to 9 or the crystal-growth method according to any of the claims 10 to 14 in a zone-melting-type or a Czochralski-type or a Bridgman-type apparatus or method for growing crystals (21).

16. Use of the crystal-growth apparatus (10, 10', 10") according to any of the claims 1 to 9 or the crystal-growth method according to any of the claims 10 to 14 for thermal treatment to reduce crack formation or thermal stress in crystals (21) grown from a molten feed material (23) and/or to facilitate the melting process of the feed material (23).
